# EUROPEAN PATENT SPECIFICATION

(11) **EP 2 214 178 B1**
(45) Date of publication and mention of the grant of the patent: **03.01.2018**
(21) Application number: 08848725.1
(22) Date of filing: 11.11.2008
(51) Int. Cl.: H05K 9/00, H05K 3/18, C23C 18/16, C23C 18/28

(54) **PROCESS FOR PRODUCING TRANSPARENT ELECTROMAGNETIC SHIELDING MATERIAL**
PROZESS ZUM HERSTELLEN EINES TRANSPARENTEN MATERIALS ZUR ELEKTROMAGNETISCHEN ABSCHIRMUNG
PROCÉDÉ DE FABRICATION DE MATÉRIAU DE BLINDAGE ÉLECTROMAGNÉTIQUE TRANSPARENT

(30) Priority: 13.11.2007 JP 2007293872
(43) Date of publication of application: 04.08.2010
(73) Proprietor: Seiren Co., Ltd., Fukui-shi Fukui 918-8560 (JP)
(72) Inventor: HAYASHI, Hiroyuki, Fukui-shi Fukui 918-8560 (JP); GOTO, Masatoshi, Fukui-shi Fukui 918-8560 (JP); OTSUKA, Rentaro, Fukui-shi Fukui 918-8560 (JP)
(74) Representative: Hoffmann Eitle
(86) International application number: PCT/JP2008/070529
(87) International publication number: WO 2009/063882

(56) References cited:
- WO-A2-2006/014861
- JP-A- 2003 109 435
- JP-A- 2003 109 435
- JP-A- 2003 165 938
- JP-A- 2006 269 109
- JP-A- 2007 031 577
- US-A- 3 793 072
- US-A- 3 954 570
- US-A- 4 668 533
- US-A1- 2005 006 339
- US-A1- 2005 191 783

## Description

### Technical Field

The present invention relates to a process for producing a a transparent electromagnetic shielding material used for displays of CRT, PDP, measurement equipments or the like and an optical filter using said shielding material. More precisely, the present invention relates to a process for producing a transparent electroconductive member having excellent transparency and electromagnetic shielding performance at low cost.

### Background Art

In the past, as a method for producing a transparent electroconductive member used for a transparent electromagnetic shielding material, a transparent electrode for various types of electronic devices, a transparent sheet heating element or the like of a wide variety of display devices of CRT, PDP, a liquid crystal display, a measurement equipment or the like, it is proposed to apply a electroconductive metallic mesh on a transparent base material. However, this method has a problem that brightness of a display screen as a whole would decrease when pursuing a sufficient electromagnetic shielding effect.

It is also proposed to form a transparent electroconductive membrane such as ITO on a transparent base material by deposition, sputtering or the like (Patent Document 1). However, the transparent electroconductive member obtained by this method is poor in electroconductivity compared with a metallic mesh while excellent in transparency.

It is also proposed to form a metallic thin membrane mesh pattern by forming a metallic thin membrane on a transparent base material by plating, deposition or the like and processing by photolithography (Patent Document 2). However, while the transparent electroconductive member obtained by this method is excellent in electroconductivity, this method is wasteful and high in cost since great mass of metal is removed by etching.

It is also proposed to carry out pattern printing on a transparent base material using a paste containing an electroless plating catalyst to form a metallic thin membrane on said pattern by plating (Patent Document 3). However, the paste containing an electroless plating catalyst used in this method is expensive and the method of pattern printing using such an expensive paste is high in cost because the catalyst which is not involved in the plating reaction has to be consume away and wasteful.

Patent Document 1: Jpn. Pat. Gazette No. 2633340
Patent Document 2: Jpn. Pat. Laid-Open Publication No. 2000-137442
Patent Document 3: Jpn. Pat. Gazette No. 3895229

US 2005/0191783 A1 relates to a method of forming an electrode in a space enclosed by partition walls in a plasma display panel. In one embodiment, an address electrode is formed on a rear substrate of a plasma display panel by a method in which a reducing agent is discharged by an ink-jet method and, after fixing the reducing agent, the substrate is immersed into a plating solution to reduce the plating catalytic metal. US 2005/006339 A1 relates generally to printing of metals using an electroless process. Specifically, a method of forming metal patterns on a substrate is claimed in the document, which involves ink-jetting a metal composition including a metal salt on a pattern formed on an electroless active layer and ink-jetting a reducing agent composition on the pattern, wherein the reducing agents contacts the metal composition and reacts with the metal salt to form a reduced metal. None of the above U.S. patent applications deals with the production of a transparent electromagnetic shielding material.

US 4,668,533 deals with the use of ink-jet printing for making printed circuit boards. In Example I of US 3,793,072, a polyimide sheet is coated or sensitized with a tin colloidal sensitizing solution. Then, a rubber stamp, having a distinct surface pattern, is immersed in an aqueous solution of KMnO₄ and sulfuric acid, and the stamp is impressed on the coated surface to delineate a first pattern incapable of reducing an activating metal ion to an activating metal. The pattern-delineated substrate is then immersed in an aqueous PdCl₂ solution whereby a palladium metal-deposited pattern is obtained, which is then immersed in a conventional electroless copper bath. US 3,954,570 is concerned with a process for depositing an electroless metal on a polyimide. The process comprises the steps of masking a selected area on the polyimide surface, exposing unmasked portions of the polyimide surface to an open flame, contacting the unmasked and flame-sensitized surfaces with a catalyst solution whereby a catalytic amount of a catalyst is deposited on the catalyzed polyimide, and depositing on the catalyzed polyimide surface a metal from a electroless bath solution. Thereby, the catalyst solution can be a solution comprised of palladous chloride, stannous chloride, stannic chloride and hydrochloric acid.

JP 2003 109435 (A) relates to a conductive film composed of a metallic ultrafine particle catalyst layer formed in a prescribed pattern on a transparent base substance and a metallic layer formed on the metallic ultrafine particle catalyst layer. In the manufacturing method for the transparent conductive film, pattern printing is applied on the transparent base substance by paste containing electroless plating catalyst, and electroless plating treatment is applied on the pattern-printed electroless plating catalyst, in order to form a transparent conductive metallic layer only on a pattern-printed part.

### Disclosure of the Invention

### Problems to be Solved by the Invention

The problem to be solved by the present invention is to provide a process for producing a transparent electromagnetic shielding material excellent in transparency and electroconductivity at low cost.

### Means for Solving the Problems

The inventors of the present invention paid intensive efforts to dissolve the above-mentioned problems and, as a result, they found that a transparent electromagnetic shielding material excellent in transparency and electroconductivity can be produced at extremely low cost by forming a pattern layer on a transparent base material using an ink containing a reducing agent, then forming a patterned electroless plating catalyst layer by applying a solution containing metal ions which can function as an electroless plating catalyst on said pattern layer to reduce the metal ions, and thereafter forming an electroconductive metal layer by plating treatment on the electroless plating catalyst layer, and thus completed the present invention.

Thus, the present invention relates to a process for producing a transparent electromagnetic shielding material as defined in the appending Claim 1.
The present invention also relates to an optical filter using the transparent electromagnetic shielding material produced by the production process of the invention (Claim 8), as well as an image display apparatus using said optical filter (Claim 9). Preferred embodiments of the present invention are subject of the dependent claims.

### Effects of the Invention

According to the present invention, since the electroless plating catalyst layer is formed on a patterned layer of ink containing a reducing agent, it is possible to produce a transparent electromagnetic shielding material excellent in transparency and electroconductivity at extremely low cost without wasting an expensive electroconductive paste and electroless plating catalyst, compared with a method of forming a lattice-shaped electroconductive thin membrane by etching using an electroconductive paste or a method of patterning after forming an expensive electroless plating catalyst layer.

### Best Mode for Carrying Out the Invention

The process for producing a transparent electromagnetic shielding material of the present invention is characterized in that it comprises the steps (a), (b) and (c) as defined in the appended claim 1.

### 1. Step (a) : a step of forming a reducing agent-containing pattern layer

In the step (a) of the present invention, pattern printing is carried out on a transparent base material using an ink containing a reducing agent to form a reducing agent-containing pattern layer.

### (1) Transparent Base Material

Examples of the transparent base materials used for the present invention include a film of polyester resins such as polyethylene terephthalate, polybutylene terephthalate, polyethylene naphthalate, polyethylene terephthalate-isophthalate copolymer and terephthalic acid-cyclohexane dimethanol-ethyleneglycol copolymer, polyamide resins such as nylon 6, polyolefin resins such as polypropylene and polymethylpentene, acrylic resins such as polyacrylate, polymethacrylate and polymethylmethacrylate, styrene resins such as an ABS resin, cellulose resins such as triacetyl cellulose, imide resins and polycarbonate.

Among them, a film of polyester resins such as polyethylene terephthalate and polyethylene naphthalate is preferably used because it has excellent transparency and heat resistance and is low in cost. Especially, a film of polyethylene terephthalate is best.

While the thickness of the transparent base plate is not particularly limited, the thickness thereof is normally in the range around 10 µm to 1000 µm, preferably in the range around 50 µm to 500 µm. When the thickness is too thin, strength as a member may become too low. When it is too thick, it may become impractical from the viewpoint of weight.

### (2) Reducing agent

The reducing agent used for the present invention is not limited as long as it is a substance which can reduce metal ions to metal by contacting with metal ions which can be an electroless plating catalyst, and can itself be oxidized. For example, a particle of electrochemically poorer metal than catalyst metal such as Pb, Sn, Ni, Co, Zn, Ti and Cu, or a salt of Sn(II), Fe(II) and the like can be used.

Among them, it is preferable to use a salt of metal selected from the group consisting of Sn(II) and Fe(II), and it is more preferable to use a salt of Sn(II).

Examples of metal salts include a chloride salt, a sulfate salt, an oxalate salt and an acetate salt, more preferably a chloride salt and a sulfate salt. Examples of particularly preferable metal salts include a metal salt selected from the group consisting of SnCl₂ and SnSO₄.

### (3) Ink Containing Reducing agent

The ink containing a reducing agent to be used for the present invention ("a reducing agent-containing ink", hereinafter) is the one containing a binder resin and a solvent in addition to the above-mentioned reducing agent. Additionally, the reducing agent-containing ink of the present invention comprises a particulate substance such as organic or inorganic particles, a cross-linking agent, other additives or the like in addition to the binder resin and the solvent. Examples of the other additives include a viscosity adjuster, a surface adjuster, a dispersing agent or the like.

### (i) Binder Resin

The binder resin is blended for the purpose of imparting suitable viscosity to the ink for its printing method and improving a bonding strength between the reducing agent and the transparent base material. As for blending amount, when the amount is too small, adhesiveness of the reducing agent-containing pattern layer may be deteriorated. When the amount is too large, precipitation performance of plated metal in the process of plating treatment after forming an electroless plating catalyst layer may be deteriorated.

Examples of the binder resins include polyester resins, acrylic resins, vinyl resins such as vinyl acetate, vinyl chloride, PVA and PVB, polyurethane resins, polyimide resins, polyamide resins, phenolic resins, phenoxy resins and alkyd resins.

Among them, polyester resins and polyurethane resins are preferable. Examples of the polyester resins include polyethylene terephthalate, polybutylene terephthalate and polyethylene naphthalate. Among them, polyethylene terephthalate is particularly preferable.

### (ii) Solvent

The solvent in the reducing agent-containing ink is blended for the purpose of dissolving the binder resin and giving the ink fluidity. The solvent having drying property suitable for corresponding printing methods can be used independently or more than one of the solvents can be used in combination with each other accordingly.

Examples of the solvents include water, alcohols such as methanol, ethanol and isopropyl alcohol, ketones such as acetone, methyl ethyl ketone, methyl isobutyl ketone and cyclohexanone, aromatic hydrocarbons such as toluene and xylene, polyalkylene glycols and the derivatives thereof such as ethyleneglycol, ethyleneglycol ethylether, ethyleneglycol butylether, diethyleneglycol, diethyleneglycol ethylether acetate, ethyleneglycol butylether acetate, propyleneglycol, propyleneglycol methylether, propyleneglycol methylether acetate and dipropyleneglycol methylether, acetic esters such as ethyl acetate and butyl acetate, γ-butyrolactone, N-methyl pyrrolidone, isophorone, dimethyl sulfoxide, dimethylformamide, terpineol and solvent naphtha.

### (iii) Particulate Substance

The particulate substance is blended for the purpose of forming asperity on the surface of the pattern layer and improving adhesiveness with the electroconductive metal layer by an anchor effect.

Examples of the particulate substances include inorganic particles such as silica, alumina, titania, talc, mica, kaolinite, montmorillonite, clay, barium sulfate and calcium carbonate, organic particles such as acrylic polymer particles, polyurethane particles and polystyrene particles, and carbon black.

While the particle size of the particulate substances is not particularly limited, it is preferable to use the one having the particle diameter in the range of from 0.01µm to 20µm. When the particle diameter is less than 0.01µm, the anchor effect may not be obtained. When the particle diameter is more than 20µm, uniformity of the electroconductive metal layer may not be obtained and further the thickness thereof may become too thick.

### (iv) Cross-linking Agent

The cross-linking agent is blended for the purpose of improving strength of the pattern layer by cross-linking with the binder or by cross-linking among the curing agents and improving adhesiveness of the pattern layer. Examples of the cross-linking agents include diisocyanates and a block material thereof such as tolylene diisocyanate, diphenylmethane-4,4'-diisocyanate, hexamethylene diisocyanate and isophorone diisocyanate, amino resins such as an n-butylated melamine resin, an isobutylated melamine resin, a butylated urea resin and a butylated melamine-urea copolycondensation resin, and epoxy resins such as a bisphenol A-type epoxy resin, a phenol/novolak-type epoxy resin and cresol/novolak-type epoxy resin. Furthermore, examples of curing accelerators thereof include dibutyltin dilaurate, tertiary amines and salts thereof, polybasic acid anhydrides, imidazoles, dicyan diamide, melamine, benzoguanamine, methanesulfone and para-toluenesulfonic acid.

### (v) Viscosity Adjuster

The viscosity adjuster is blended for the purpose of preventing a pattern from blurring or dripping. Examples of the viscosity adjusters include fumed silica, fumed alumina, fumed titania, organic bentonite, amide wax-type additives, hydrogenated castor oil-type additives, polyol-type additives, CMC, sodium alginate and sodium polyacrylate.

### (vi) Surface Adjuster

The surface adjuster is blended for the purpose of adjusting wetting characteristic of the ink with the base material and surface conditions of the pattern layer. Examples of the surface adjusters include additives of acrylic polymers, silicones and fluorocarbons.

### (vii) Dispersing Agent

The dispersing agent is blended for the purpose of improving stability of dispersion state of the ink. Examples thereof include polymer surfactants.

### (viii) Blending Ratio

While the content of the reducing agent in the reducing agent-containing ink to be used for the present invention is not particularly limited, it is preferably from 0.1 to 50% by weight, more preferably from 1 to 30% by weight based upon the total amount of solid content in the reducing agent-containing ink. When the content of the reducing agent is too small, precipitation performance of plated metal in the process of plating treatment after forming an electroless plating catalyst layer may be deteriorated. When the content is too large, adhesiveness of the reducing agent-containing pattern layer may be deteriorated.

While the content of the binder resin is not particularly limited, it is preferably from 5 to 90% by weight, more preferably from 20 to 70% by weight based upon the total amount of solid content in the reducing agent-containing ink. When the content of the binder resin is too small, adhesiveness of the reducing agent-containing pattern layer may be deteriorated. When the content is too large, precipitation performance of plated metal in the process of plating treatment after forming an electroless plating catalyst layer may be deteriorated.

While the content of the solvent is not particularly limited, it is preferably from 30 to 99% by weight, more preferably from 50 to 95% by weight based upon the total amount of the reducing agent-containing ink. When the content of the solvent is too small, viscosity may become too high which may cause difficulty in printing. When the content is too large, viscosity may become too low which may cause difficulty in printing.

While the content of the particulate substance is not particularly limited, it is preferably from 10 to 95% by weight, more preferably from 30 to 80% by weight based upon the total amount of solid content in the reducing agent-containing ink. When the content of the particulate substance is too small, improving effect of adhesiveness between the electroconductive metal layer and the reducing agent-containing pattern layer may not be obtained. When the content is too large, precipitation performance of plated metal in the process of plating treatment after forming an electroless plating catalyst layer may be deteriorated.

While the content of the cross-linking agent is not particularly limited, it is preferably from 5 to 50% by weight, more preferably from 10 to 30% by weight based upon sum total of the amount of the binder resin and the cross-linking agent in the reducing agent-containing ink. When the content of the cross-linking agent is too small, improving effect of adhesiveness between the reducing agent-containing pattern layer and the transparent base material may not be obtained. When the content is too large, strength of the pattern layer may be deteriorated caused by uncured substances.

While the content of the viscosity adjuster is not particularly limited, it is preferably from 0.05 to 20% by weight, more preferably from 0.1 to 10% by weight based upon the total amount of the reducing agent-containing ink. When the content of the viscosity adjuster is too small, preventing effect of a pattern from blurring and dripping may not be obtained. When the content is too large, printing may become difficult because of the loss of fluidity.

While the content of the surface adjuster is not particularly limited, it is preferably from 0.01 to 10% by weight, more preferably from 0. 05 to 5% by weight based upon the total amount of the reducing agent-containing ink. When the content of the surface adjuster is too small, improving effect of wetting characteristic of the ink or adjusting effect of the surface conditions may not be obtained. When the content is too large, precipitation performance of plated metal in the process of plating treatment after forming an electroless plating catalyst layer may be deteriorated.

While the content of the dispersing agent is not particularly limited, it is preferably from 10 to 200% by weight, more preferably from 30 to 150% by weight based upon the amount of particulate substrates in the reducing agent-containing ink. When the content of the dispersing agent is too small, the dispersion state of the ink may be deteriorated. When the content is too large, precipitation performance of plated metal in the process of plating treatment after forming an electroless plating catalyst layer may be deteriorated.

### (4) Formation of Reducing Agent-Containing Pattern Layer

n the step (a) of the present invention, a desired pattern is printed on the transparent base material using the above-mentioned reducing agent-containing ink and then the solvent component is dried, whereby a reducing agent-containing pattern layer is formed. The method of printing is gravure printing, or screen printing. For each printing method, commonly known means can be used.

In the case of screen printing, the thickness of emulsion for masking is preferably 1 to 30µm.

Preferable drying conditions in the process of drying the solvent component are as follows; drying temperature: 20-150°C, time of drying: from 5 seconds to 60 minutes.

While the thickness of the reducing agent-containing pattern layer thus obtained is not particularly limited, it is preferably 0.5 to 15µm. The pattern form of the reducing agent-containing pattern layer can be a stripe and/or a mesh. For example, a mesh can be formed by combining more than one form such as polygon such as triangle, square, hexagon and octagon, circle or the like with each other.

The width "W" of the pattern layer is preferably 5 to 50µm, and the space between a line and a line is preferably 100 to 700µm. In addition, a bias can be applied in order to eliminate moire after forming an electroconductive metal layer. When the width W of the pattern layer 2 is less than 5µm, electroconductivity may become deficient when the electroconductive metal layer is formed, which may cause unable to shield electromagnetic wave sufficiently. When the width W is more than 50µm, transparency may be deteriorated. The space between a line and a line is less than 100µm, transparency may be deteriorated. When the space is more than 700µm, electroconductivity may be deteriorated.

### 2. Step (b) : a step of forming an electroless plating catalyst layer

In the step (b) of the present invention, a metal ion solution containing metal ions, which can function as an electroless plating catalyst upon reduction, is applied on said reducing agent-containing pattern layer, and the metal ion is reduced by contact between the reducing agent and the metal ion to form an electroless plating catalyst layer.

### (1) Metal Ion Solution

The metal ion solution to be used for the present invention contains metal ions which can function as an electroless plating catalyst upon reduction. Examples of the metal ions which can function as an electroless plating catalyst upon reduction include ions of metal such as Ag, Au, Pd, Pt and Rh. Among them, Pd(II) and Ag(I) are particularly preferable.

The solution containing these metal ions can be obtained by dissolving metal salts into a solution. Examples of the metal salts to be used here include a chloride salt, a bromide salt, an acetate salt, a nitrate salt and a citrate salt. More precisely, a salt of Pd(II) such as PdCl₂, PdBr₂ and Pd(CH₃COO)₂, a salt of Ag(I) such as CH₃COOAg, AgNO₃ and silver (I) citrate and the like.

Examples of the preferable solvents to be used for the metal ion solution include water. While the concentration of metal salts in the above-mentioned metal ion solution depends on the sort of metal salts to be used, it is preferable to blend PdCl₂ so that the concentration becomes 0.01 to 3g/l in the case of using PdCl₂. In addition, it is preferable to blend hydrochloric acid at the same time in order to dissolve the metal salt. With regard to the blending ratio of hydrochloric acid, it is preferable to blend 35%-hydrochloric acid in the range around 1 to 30 ml/l.

The above-mentioned metal ion solution can also contain alkali metal salts such as sodium chloride, potassium chloride, sodium bromide and potassium bromide for the purpose of improving solubility of the metal salt. While the blending amount thereof is not particularly limited, it is preferable to blend them so that the concentration becomes 0.1 to 10 g/l.

### (2) Formation of Electroless Plating Catalyst Layer

The above-mentioned metal ion solution is applied on the reducing agent-containing pattern layer formed in the former step (a). Then, by contacting the metal ion contained in said metal ion solution which can function as an electroless plating catalyst with the reducing agent, the metal ion is reduced to become catalyst metal and an electroless plating catalyst layer is formed on the pattern layer (catalyst adsorption treatment).

The method for applying the metal ion solution is not particularly limited and any methods such as immersion, spray and the like can be employed. While the temperature of catalyst adsorption treatment and the time for the treatment is not particularly limited, it is preferable to leave the pattern layer at rest after applying the metal ion solution for 10 seconds to 60 minutes (more preferably for 30 seconds to 10 minutes) at 10-100°C (more preferably 30-60°C) to contact the metal ion and the reducing agent, whereby the metal ion and the reducing agent can react sufficiently with each other, and the metal ion is reduced.

### 3. Step (c): a step of forming an electroconductive metal layer

In the step (c) of the present invention, an electroconductive metal layer is formed by plating treatment on the above-mentioned electroless plating catalyst layer.

### (1) Plating Treatment

Examples of metals to be used for the plating treatment include metals used for usual electroless plating treatment such as copper(Cu), nickel(Ni), gold(Au), silver(Ag), tin(Sn) and zinc(Zn) and alloys thereof.

For example, an electroless Cu plating bath, an electroless Ni-P plating bath, an electroless Ni-B plating bath or an electroless Au plating bath can be used.

### (2) Electroconductive Metal Layer

Since the electroconductive metal layer of the present invention is formed on the electroless plating catalyst layer which is formed on the pattern-printed reducing agent-containing pattern layer, the electroconductive metal layer is formed only on the pattern-printed part selectively.

The width "W" of the electroconductive metal layer is preferably 5 to 50µm and the space between a line and a line is preferably 100 to 700µm. In addition, a bias can be applied in order to eliminate moire. When the width W of the electroconductive metal layer 2 is less than 5µm, electroconductivity may become deficient, which may cause unable to shield electromagnetic wave sufficiently. When the width W is more than 50µm, transparency may be deteriorated. The space between a line and a line is less than 100µm, transparency may be deteriorated. When the space is more than 700µm, electroconductivity may be deteriorated.

The thickness "T" of the electroconductive metal layer is preferably 0.1 to 15µm, and the formula "1≦W/T≦500" is preferably fulfilled, wherein W is the width of the metal layer and T is the height of the metal layer, whereby contamination of bubbles can be prevented at the time of laminating with other base materials. When W/T is less than 1, transparency may be deteriorated because of contamination of bubbles at the time of laminating with other base materials. When W/T is more than 500, transparency may be deteriorated because of the electroconductive metal layer itself and/or the electroconductive metal layer may be peeled off easily.

In this way, the reducing agent-containing pattern layer is formed by pattern printing using the reducing agent-containing ink, then the electroless plating catalyst layer is formed thereon by catalyst adsorption treatment, and thereafter plating treatment is carried out, whereby electroless plating is carried out only on the printed place selectively without wasting the electroless plating catalyst. Therefore, the cost of production can be drastically lowered.

### 4. Other Steps

In the process of the present invention, after forming the electroconductive metal layer by plating treatment, it is possible to change adhesiveness and/or color by heat treatment to improve bonding strength with films, blackening by oxidation or sulfuration, or the like.

According to the present invention, in addition, same or other metal layers can be overlapped by electroplating, if necessary, on the electroconductive metal layer formed by the above-mentioned plating treatment.

For the electroplating, metals normally employed such as copper, nickel and alloys thereof can be used. Furthermore, it is possible to change electroconductivity and/or color by additional electroless plating to improve electroconductivity, blackening these metal layers by oxidation or sulfuration, or the like. By blackening the electroconductive metal layer, benefits that transparency of the film is improved can be obtained.

### Examples

The present invention will be described in more detail below referring to Examples. Note that the scope of the present invention is not limited by the following examples.

The transparent electroconductive film obtained by the following Examples and Comparative Examples were evaluated by the methods below:

### (1) Height T of Electroconductive Metal Layer

A piece of the film was cut out, and then a slice was cut out therefrom in the cross-sectional direction by a microtome. The slice was observed and measured by using a laser microscope manufactured by Olympus Optical Co. , Ltd, trade name "LEXT OLS3000".

### (2) Width W of Electroconductive Metal Layer

Observing the surface of the metal layer of the transparent electroconductive film, the width of the metal layer was measured by using a laser microscope manufactured by Olympus Optical Co., Ltd, trade name "LEXT OLS3000".

### (3) Electroconductivity

Measured by using "Loresta AP" (a 4-pin probe method), manufactured by Mitsubishi Chemical Corporation.

### (4) Transmittance

Transmittance of a light (visible ray) at a wavelength of 400 to 700 nm was measured by using a spectromicroscope manufactured by Otsuka Electronics Co., Ltd., trade name "MCPD2000".

### [Example 1] (Screen Printing)

### (Preparation of Reducing agent-containing Ink)

A mixed solution of 1 part by weight of SnCl₂, 10 parts by weight of carbon black manufactured by Tokai Carbon Co., Ltd., trade name "TOKABLACK #5500", 33.3 parts by weight of 30%-cyclohexanone solution of a polyester resin manufactured by TOYOBO CO., LTD, trade name "VYLON 270", and 25.7 parts by weight of cyclohexanone was dispersed by beadsmill to obtain a reducing agent-containing ink.

### (Formation of Pattern Layer)

The above-mentioned reducing agent-containing ink was printed by screen printing on the surface of a polyethylene terephthalate (PET) film with a thickness of 100µm having transparency of 92% and refraction index of 1.55, by using a screen plate having a square lattice pattern with an emulsion thickness of 15µm, a line width of 20µm and a line distance of 200µm to form a reducing agent-containing pattern layer.

### (Catalyst Adsorption Treatment)

The catalyst adsorption treatment was carried out by immersing the pattern layer-formed film in a solution containing PdCl₂: 0. 3g/l and 35%HCl: 3ml/l for 2 minutes at 40°C, and then washing the film in water.

### (Electroless Plating Treatment)

Electroless copper plating (electroless plating solution: manufactured by OKUNO CHEMICAL INDUSTRIES CO., LTD, trade name "OPC-750 electroless copper M", was carried out on the surface of the film after catalyst adsorption treatment to obtain a transparent electroconductive film. In addition, an electrolytic copper plating treatment was carried out by using an electrolytic copper plating solution (copper sulfate solution) to obtain a transparent electroconductive film of the present invention wherein the width W of the electroconductive metal layer was 20µm, the thickness T thereof was 5µm and W/T=4. Furthermore, an EVA-type adhesive was coated on the surface of the transparent electroconductive film to laminate the film with a PET film having an antireflection layer.

### [Example 2] (Gravure Printing)

### (Preparation of Reducing agent-containing Ink)

A mixed solution of 1 part by weight of SnCl₂, 10 parts by weight of carbon black manufactured by Tokai Carbon Co. , Ltd. , trade name "TOKABLACK #5500", 33.3 parts by weight of 30%-cyclohexanone solution of a polyester resin manufactured by TOYOBO CO., LTD, trade name "VYLON 270", and 55.7 parts by weight of cyclohexanone was dispersed by beadsmill to obtain a reducing agent-containing ink.

### (Formation of Pattern Layer)

The above-mentioned reducing agent-containing ink was printed by gravure printing on the surface of a polyethylene terephthalate (PET) film with a thickness of 100µm having transparency of 92% and refraction index of 1.55, by using a gravure plate having a square lattice pattern with a line width of 20µm, a line distance of 200µm and a line depth of 7µm to form a reducing agent-containing pattern layer.

### (Catalyst Adsorption Treatment)

The catalyst adsorption treatment was carried out by immersing the pattern layer-formed film in a solution containing PdCl₂: 0.3g/l and 35%HCl: 3ml/l for 2 minutes at 40°C, and then washing the film in water.

### (Electroless Plating Treatment)

Electroless copper plating (electroless plating solution: manufactured by OKUNO CHEMICAL INDUSTRIES CO., LTD, trade name "OPC-750 electroless copper M", was carried out on the surface of the film after catalyst adsorption treatment to obtain a transparent electroconductive film. In addition, an electrolytic copper plating treatment was carried out by using an electrolytic copper plating solution (copper sulfate solution) to obtain a transparent electroconductive film of the present invention wherein the width W of the electroconductive metal layer was 20µm, the thickness T thereof was 2µm and W/T=10. Furthermore, an EVA-type adhesive was coated on the surface of the transparent electroconductive film to laminate the film with a PET film having an antireflection layer.

### [Comparative Example 1] (Catalyst Ink Printing)

A palladium catalyst ink was printed by screen printing on the surface of a polyethylene terephthalate (PET) film with a thickness of 100µm having transparency of 92% and refraction index of 1.55, by using a screen plate having a square lattice pattern with an emulsion thickness of 15µm, a line width of 20µm and a line distance of 200µm to form a pattern layer containing an electroless plating catalyst. An electroless copper plating treatment was carried out on this film by the same method as Example 1 to obtain a transparent electroconductive film wherein the width W of the electroconductive metal layer was 20µm, the thickness T thereof was 5µm and W/T=4. Furthermore, an EVA-type adhesive was coated on the surface of the transparent electroconductive film to laminate the film with a PET film having an antireflection layer.

The results were shown in Table 1.

### Table 1]

**Table 1**

| | Width of the metal layer W | Height of the metal layer T | W/T | Electroconductivity | Transmittance | Manufacturing Cost |
|---|---|---|---|---|---|---|
| Example 1 | 20 | 5 | 4 | 0.1Ω/□ | 80 | ○ |
| Example 2 | 20 | 2 | 10 | 0.1Ω/□ | 80 | ○ |
| Comparative Example 1 | 20 | 5 | 4 | 0.1Ω/□ | 80 | × |

### Industrial Applicability

According to the present invention, a transparent electromagnetic shielding material having excellent transparency and electroconductivity can be produced at low cost. The transparent electromagnetic shielding material can be used for various display devices such as CRT, PDP, a liquid crystal display, measurement equipments or the like.

## Claims

1. A process for producing a transparent electromagnetic shielding material having a transparent base material and an electroconductive metal layer comprising the following steps (a), (b) and (c):
(a) a step wherein pattern printing is carried out by screen printing or gravure printing on said transparent base material using an ink containing a reducing agent, a particulate substance, a binder resin and a solvent to form a reducing agent-containing pattern layer,
(b) a step wherein a metal ion solution containing metal ions, which can function as an electroless plating catalyst upon reduction, is applied on said reducing agent-containing pattern layer, and the metal ion is reduced by contact between the reducing agent and the metal ion to form an electroless plating catalyst layer, and
(c) a step wherein an electroconductive metal layer is formed by plating treatment on said electroless plating catalyst layer.

2. The process for producing a transparent electromagnetic shielding material according to claim 1, wherein said reducing agent is a salt of a metal selected from the group consisting of Sn(II) and Fe(II).

3. The process for producing a transparent electromagnetic shielding material according to claim 2, wherein said salt of a metal is selected from the group consisting of SnCl₂, Sn(OH)₂ and SnSO₄.

4. The process for producing a transparent electromagnetic shielding material according to claims 1 to 3, wherein said solution containing metal ions which can function as an electroless plating catalyst upon reduction is a solution of a salt of metal selected from the group consisting of Ag, Au, Pd, Pt and Rh.

5. The process for producing a transparent electromagnetic shielding material according to claim 4, wherein said solution of a salt of metal is a solution of a salt of Pd(II) or a salt of Ag(I).

6. The process for producing a transparent electromagnetic shielding material according to claim 5, wherein said solution of a salt of Pd(II) or a salt of Ag(I) is an aqueous solution of a metal salt selected from the group consisting of PdCl₂, PdBr₂, Pd(CH₃COO)₂, CH₃COOAg, AgNO₃ and silver(I) citrate.

7. The process for producing a transparent electromagnetic shielding material according to claims 1 to 6, wherein said transparent base material is a polyethylene terephthalate film.

8. An optical filter using said transparent electromagnetic shielding material produced by the process according to any one of claims 1 to 7.

9. An image display apparatus using said optical filter according to claim 8.

## Patentansprüche

1. Verfahren zur Herstellung eines transparenten Materials zur elektromagnetischen Abschirmung, das ein transparentes Basismaterial und eine elektrisch leitfähige Metallschicht enthält, das die folgenden Schritte (a), (b) und (c) umfasst:
(a) einen Schritt, in dem Musterdruck durch Siebdruck oder Tiefdruck auf dem transparenten Basismaterial unter Verwendung einer Farbe, die ein Reduktionsmittel enthält, einer teilchenförmigen Substanz, eines Bindemittelharzes und eines Lösungsmittels durchgeführt wird, um eine Musterschicht, die Reduktionsmittel enthält, zu bilden,
(b) einen Schritt, in dem eine Metallionenlösung, die Metallionen enthält und die bei Reduktion als ein Katalysator für die stromlose Plattierung fungieren kann, auf die Musterschicht, die Reduktionsmittel enthält, aufgebracht wird, und das Metallion durch Kontakt zwischen dem Reduktionsmittel und dem Metallion reduziert wird, um eine Katalysatorschicht für die stromlose Plattierung zu bilden, und
(c) einen Schritt, in dem eine elektrisch leitfähige Metallschicht durch Plattierungsbehandlung auf der Katalysatorschicht für die stromlose Plattierung gebildet wird.

2. Verfahren zur Herstellung eines transparenten Materials zur elektromagnetischen Abschirmung gemäß Anspruch 1, wobei das Reduktionsmittel ein Salz eines Metalls, ausgewählt aus der Gruppe bestehend aus Sn(II) und Fe(II), ist.

3. Verfahren zur Herstellung eines transparenten Materials zur elektromagnetischen Abschirmung gemäß Anspruch 2, wobei das Salz eines Metalls ausgewählt ist aus der Gruppe bestehend aus SnCl₂, Sn(OH)₂ und SnSO₄.

4. Verfahren zur Herstellung eines transparenten Materials zur elektromagnetischen Abschirmung gemäß mindestens einem der Ansprüche 1 bis 3, wobei die Lösung, die Metallionen enthält und die bei Reduktion als ein Katalysator für die stromlose Plattierung fungieren kann, eine Lösung eines Metallsalzes, ausgewählt aus der Gruppe bestehend aus Ag, Au, Pd, Pt und Rh, ist.

5. Verfahren zur Herstellung eines transparenten Materials zur elektromagnetischen Abschirmung gemäß Anspruch 4, wobei die Lösung eines Metallsalzes eine Lösung eines Pd(II)-Salzes oder eines Ag(I)-Salzes ist.

6. Verfahren zur Herstellung eines transparenten Materials zur elektromagnetischen Abschirmung gemäß Anspruch 5, wobei die Lösung eines Pd(II)-Salzes oder eines Ag(I)-Salzes eine wässrige Lösung eines Metallsalzes, ausgewählt aus der Gruppe bestehend aus PdCl₂, PdBr₂, Pd(CH₃COO)₂, CH₃COOAg, AgNO₃ und Silber(I)citrat, ist.

7. Verfahren zur Herstellung eines transparenten Materials zur elektromagnetischen Abschirmung gemäß mindestens einem der Ansprüche 1 bis 6, wobei das transparente Basismaterial ein Polyethylenterephthalatfilm ist.

8. Optischer Filter, der das transparente Material zur elektromagnetischen Abschirmung, das durch das Verfahren gemäß mindestens einem der Ansprüche 1 bis 7 hergestellt wurde, verwendet.

9. Bildanzeigevorrichtung, die den optischen Filter gemäß Anspruch 8 verwendet.

## Revendications

1. Procédé de fabrication d'un matériau de blindage électromagnétique transparent comportant un matériau de base transparent et une couche métallique électro-conductrice comprenant les étapes (a), (b) et (c) suivantes :
(a) une étape dans laquelle une impression de motifs est réalisée par sérigraphie ou impression par gravure sur ledit matériau de base transparent en utilisant une encre contenant un agent réducteur, une substance particulaire, une résine liante et un solvant afin de former une couche à motifs contenant un agent réducteur ;
(b) une étape dans laquelle une solution d'ions métalliques contenant des ions métalliques, pouvant fonctionner comme un catalyseur de placage auto-catalytique par réduction, est appliquée sur ladite couche à motifs contenant un agent réducteur, et l'ion métallique est réduit par contact entre l'agent réducteur et l'ion métallique afin de former une couche de catalyseur de placage auto-catalytique ; et
(c) une étape dans laquelle une couche métallique électro-conductrice est formée par un traitement de placage sur ladite couche de catalyseur de placage auto-catalytique.

2. Procédé de fabrication d'un matériau de blindage électromagnétique transparent selon la revendication 1, dans lequel ledit agent réducteur est un sel d'un métal choisi dans le groupe constitué par Sn(II) et Fe(II).

3. Procédé de fabrication d'un matériau de blindage électromagnétique transparent selon la revendication 2, dans lequel ledit sel d'un métal est choisi dans le groupe constitué par SnCl₂, Sn(OH)₂ et SnSO₄.

4. Procédé de fabrication d'un matériau de blindage électromagnétique transparent selon les revendications 1 à 3, dans lequel ladite solution contenant des ions métalliques qui peut fonctionner comme catalyseur de placage auto-catalytique par réduction est une solution d'un sel métallique choisi dans le groupe constitué par Ag, Au, Pd, Pt et Rh.

5. Procédé de fabrication d'un matériau de blindage électromagnétique transparent selon la revendication 4, dans lequel ladite solution d'un sel métallique est une solution d'un sel de Pd(II) ou d'un sel d'Ag(I).

6. Procédé de fabrication d'un matériau de blindage électromagnétique transparent selon la revendication 5, dans lequel ladite solution d'un sel de Pd(II) ou d'un sel d'Ag(I) est une solution aqueuse d'un sel métallique choisi dans le groupe constitué par PdCl₂, PdBr₂, Pd(CH₃COO)₂, CH₃COOAg, AgNO₃ et le citrate d'argent (I).

7. Procédé de fabrication d'un matériau de blindage électromagnétique transparent selon les revendications 1 à 6, dans lequel ledit matériau de base transparent est un film de polyéthylène téréphtalate.

8. Filtre optique utilisant ledit matériau de blindage électromagnétique transparent fabriqué par le procédé selon l'une quelconque des revendications 1 à 7.

9. Appareil d'affichage d'image utilisant ledit filtre optique selon la revendication 8.
